Europäisches Patentamt

European Patent Office

Office européen des brevets

(19)

(11) Numéro de publication: **0 321 328**
**A1**

(12) **DEMANDE DE BREVET EUROPEEN**

(21) Numéro de dépôt: **88403150.1**

(22) Date de dépôt: **12.12.88**

(51) Int. Cl.⁴: **H 01 L 21/308**
**H 01 L 33/00, H 01 S 3/06**

(30) Priorité: **18.12.87 FR 8717707**

(43) Date de publication de la demande:
**21.06.89 Bulletin 89/25**

(84) Etats contractants désignés:
**DE ES FR GB IT NL SE**

(71) Demandeur: **THOMSON-CSF**
**51, Esplanade du Général de Gaulle**
**F-92800 Puteaux (FR)**

(72) Inventeur: **Blondeau, Robert**
**Thomson-CSF SCPI 19, avenue de Messine**
**F-75008 Paris (FR)**

Rondi, Daniel
Thomson-CSF SCPI 19, avenue de Messine
F-75008 Paris (FR)

Talneau, Anne
Thomson-CSF SCPI 19, avenue de Messine
F-75008 Paris (FR)

Vilain, Gervaise
Thomson-CSF SCPI 19, avenue de Messine
F-75008 Paris (FR)

de Cremoux, Baudoin
Thomson-CSF SCPI 19, avenue de Messine
F-75008 Paris (FR)

(74) Mandataire: **Sciaux, Edmond et al**
**THOMSON-CSF SCPI**
**F-92045 PARIS LA DEFENSE CEDEX 67 (FR)**

(54) Procédé de réalisation d'un réseau de diffraction sur un matériau semi-conducteur, et dispositif opto-électronique comportant un réseau de diffraction réalisé selon ce procédé.

(57) L'invention concerne un procédé permettant de graver, avec un bon rendement de fabrication, un réseau de diffraction sur un matériau semi-conducteur, en particulier pour constituer un réseau distribué sur une structure guidante. Il consiste successivement à :
- déposer, par épitaxie, sur un substrat (S), une couche (11) de confinement optique, constituée d'un premier matériau semi-conducteur ;
- déposer, par épitaxie, une couche active (12) constituée d'un deuxième matériau semi-conducteur ;
- déposer, par épitaxie, une couche d'arrêt (13) constituée d'un troisième matériau semi-conducteur ;
- déposer, par épitaxie, une couche guidante (14) constituée d'un quatrième matériau semi-conducteur ;
- déposer une couche de résine photosensible, et la découper selon une forme à donner au réseau de diffraction qui est à réaliser ;
- attaquer la couche guidante (14), au moyen d'un agent chimique sélectif qui n'attaque pas le matériau de la couche d'arrêt (13), ni la résine, en le laissant agir jusqu'à ce que toute épaisseur de la couche guidante (14) ait été traversée, cette épaisseur étant choisie égale à la profondeur souhaitée pour le réseau de diffraction ;

Application à l'optique intégrée.

**FIG.3**

EP 0 321 328 A1

Description

**Procédé de réalisation d'un réseau de diffraction sur un matériau semi-conducteur, et dispositif opto-électronique comportant un réseau de diffraction réalisé selon ce procédé.**

L'invention concerne un procédé de réalisation d'un réseau de diffraction sur un matériau semi-conducteur, et un dispositif optique comportant un réseau de diffraction réalisé selon ce procédé. Il est connu de réaliser des lasers à semi-conducteur comportant un réseau de diffraction. Il s'agit soit de lasers à rétroaction distribuée, appelés lasers PFB (Distributed Feed Back), soit de lasers à réflecteur de Bragg appelés lasers DBR (Distributed Bragg Reflector). Ces lasers sont très intéressants par leur pureté et leur stabilité spectrales, en particulier pour des applications dans le domaine des télécommunications à longues distances et dans celui des liaisons cohérentes. De plus, la structure de ces lasers devrait se prêter particulièrement bien à l'intégration car la présence du réseau de diffraction permet de s'affranchir d'au moins une des faces clivées formant la cavité de Perrot-fabry dans un laser classique. Ces structures permettent donc de simplifier les connexions optiques avec d'autres éléments opto-électroniques tels que des modulateurs, des photo-diodes, des multiplexeurs, etc...

Cependant, les procédés connus pour réaliser un réseau de diffraction sur un matériau semi-conducteur sont délicats à mettre en oeuvre et les caractéristiques du réseau obtenu sont très difficiles à maîtriser. La réalisation d'un réseau de diffraction est l'étape la plus délicate dans la réalisation d'un laser de ces types. D'autre part, il est souhaitable d'améliorer le rendement optique de ce type de réseau.

Par exemple, un laser DFB comporte au moins :
- une couche de confinement optique, épitaxiée sur un substrat;
- une couche active ;
- une couche, dite guidante, sur laquelle est gravé un réseau de diffraction.

Classiquement le réseau de diffraction est gravé en déposant une couche de résine photosensible sur la couche guidante, puis en découpant un masque dans la résine, soit par holographie UV, soit par masquage électroni que ; puis en attaquant la couche guidante au moyen d'un agent chimique qui enlève une partie de son épaisseur dans les endroits non protégés par le masque de résine. On démontre que pour avoir un rendement élevé dans la fabrication des lasers DFB, il est nécessaire d'obtenir une profondeur de gravure bien déterminée, de l'ordre de 0,04 micron. La largeur des parties en relief doit être comprise entre 0,05 et 0,15 micron. Le pas du réseau est de l'ordre de 0,47 micron, ce qui implique que la largeur des rubans de résine constituant le masque est au moins de l'ordre de 0,15 micron. Par la technique classique d'attaque chimique, il est très difficile d'obtenir une profondeur de gravure précise et homogène sur toute la surface du réseau. L'objet de l'invention est un procédé simple et ayant un bon rendement de fabrication, pour réaliser de tels réseaux de diffraction sur un matériau semi-conducteur.

L'objet de l'invention est un procédé consistant essentiellement à déposer, par épitaxie, avant la couche guidante, une couche de matériau différent du matériau constituant la couche guidante, puis à graver celle-ci par une attaque chimique sélective, la profondeur d'attaque dans la couche étant égale à l'épaisseur même de cette couche.

Les réseaux réalisés par le procédé selon l'invention procurent un rendement optique meilleur que ceux réalisés selon l'art antérieur.

Selon l'invention un procédé de réalisation d'un réseau de diffraction sur un matériau semi-conducteur, est caractérisé en ce qu'il consiste successivement à:
- déposer, par épitaxie une première couche, dite couche d'arrêt, constituée d'un premier matériau semi-conducteur, et ayant une épaisseur comprise entre 0,005 et 0,02 micron ;
- déposer, par épitaxie, une seconde couche constituée d'un second matériau semi-conducteur ayant une composition différente de celle du premier ; et ayant une épaisseur égale à la profondeur des traits du réseau à réaliser, et comprise entre 0,01 et 0,03 micron ;
- déposer un masque ayant la forme à donner au réseau de diffraction qui est à réaliser ;
- attaquer la seconde couche à travers le masque, au moyen d'un agent chimique sélectif qui n'attaque pas le matériau de la première couche, et le laisser agir jusqu'à ce que toute l'épaisseur de la seconde couche ait été traversée ;
- enlever le masque.

L'invention sera mieux comprise et d'autres détails apparaîtront à l'aide de la description ci-dessous et des figures l'accompagnant :
     - La figure 1 représente un dispositif optique comportant un réseau de diffraction réalisé selon le procédé connu ;
     - La figure 2 représente un diagramme illustrant la nécessité de réaliser une gravure ayant une profondeur précise ;
     - La figure 3 représente un dispositif optique comportant un réseau de diffraction réalisé par le procédé selon l'invention ;
     - La figure 4 représente un diagramme illustrant la possibilité d'obtenir un bon rendement de fabrication des lasers DFB, en appliquant le procédé selon l'invention ;
     - Les figures 5 et 6 représentent deux strutures de laser DFB comportant un réseau de diffraction réalisé par le procédé selon l'invention ;
     - Les figures 7 et 8 représentent deux dispositifs optiques comportant un déphaseur et un réseau de diffraction réalisés par le procédé selon l'invention.

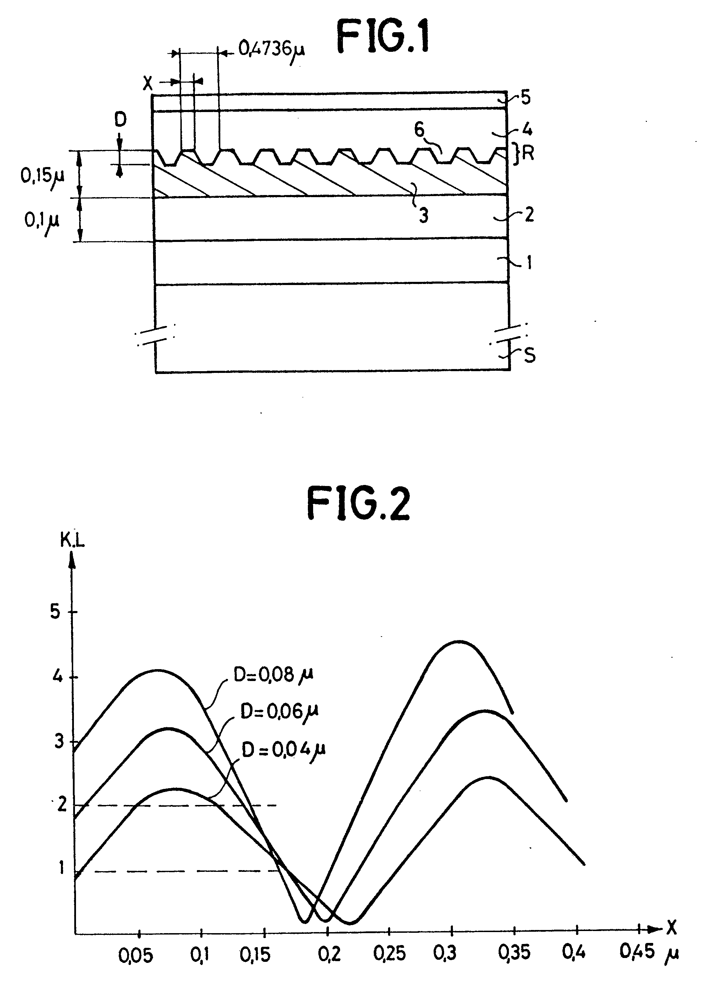

La figure 1 représente une coupe de la structure d'un laser DFB émettant à une longueur d'onde de 1,55 micron, et comportant un réseau de diffraction R réalisé selon le procédé connu. Il comporte successivement : un substrat S ; une couche de confinement optique 1, épitaxiée sur le substrat S et constituée de InP ; une couche active 2 constituée de GaInAsP ayant une largeur de bande interdite correspondant à une longueur d'onde de 1,5 micron, et ayant une épaisseur de 0,1 micron ; une couche guidante 3, sur laquelle est gravé le réseau R avec une profondeur D inférieure à l'épaisseur de la couche 3, qui est de 1,5 micron ; la couche 3 étant constituée de GaInAsP ayant une largeur de bande interdite plus grande que celle de la couche 2, correspondant par exemple à une longueur d'onde de 1,3 micron ; une couche de confinement optique 4, épitaxiée par dessus la couche 3 après que le réseau R ait été gravé sur cette couche 3 ; et une couche de contact 5.

Le réseau R est constitué de traits parallèles entre eux, ayant un pas de 0,4736 micron, et la largeur de la partie en relief constituant chaque trait a une valeur X. On montre que pour obtenir un rendement élevé dans la fabrication des lasers DFB, indépendamment du problème d'obtention d'une uniformité de l'épaisseur et de la composition des couches, il est nécessaire d'obtenir un réseau de diffraction ayant un facteur de couplage, K.L, compris entre les valeurs 1 et 2 ; K étant un coefficient de couplage et L étant la longueur du laser, généralement de l'ordre de 300 microns.

La figure 2 représente un diagramme donnant la valeur du facteur de couplage K.L du réseau, en fonction de la largeur X des parties en relief qui constituent les traits du réseau et en fonction de la profondeur D de la gravure. La pente des parties en relief est supposée faire un angle de 54° par rapport au plan des couches. Ce diagramme est tracé pour un réseau du deuxième ordre.

Il apparaît sur ce diagramme, qu'il est nécessaire d'obtenir une faible profondeur de gravure, D, de l'ordre de 0,04 micron et qu'il est nécessaire que la largeur X des parties en relief soit comprise entre 0,05 et 0,15 micron, afin que le facteur de couplage K.L soit compris entre 1 et 2. Le pas du réseau étant de 0,4736 micron, cela implique que les rubans de résine constituant le masque de gravure aient une largeur constante de l'ordre de 0,15 micron. Le procédé classique permet difficilement d'obtenir une telle profondeur et une telle largeur de gravure, d'une manière précise, uniforme et reproductible. Le rendement de fabrication est donc assez faible.

Le procédé selon l'invention, au contraire procure à la fois un bon rendement de fabrication et un bon rendement optique.

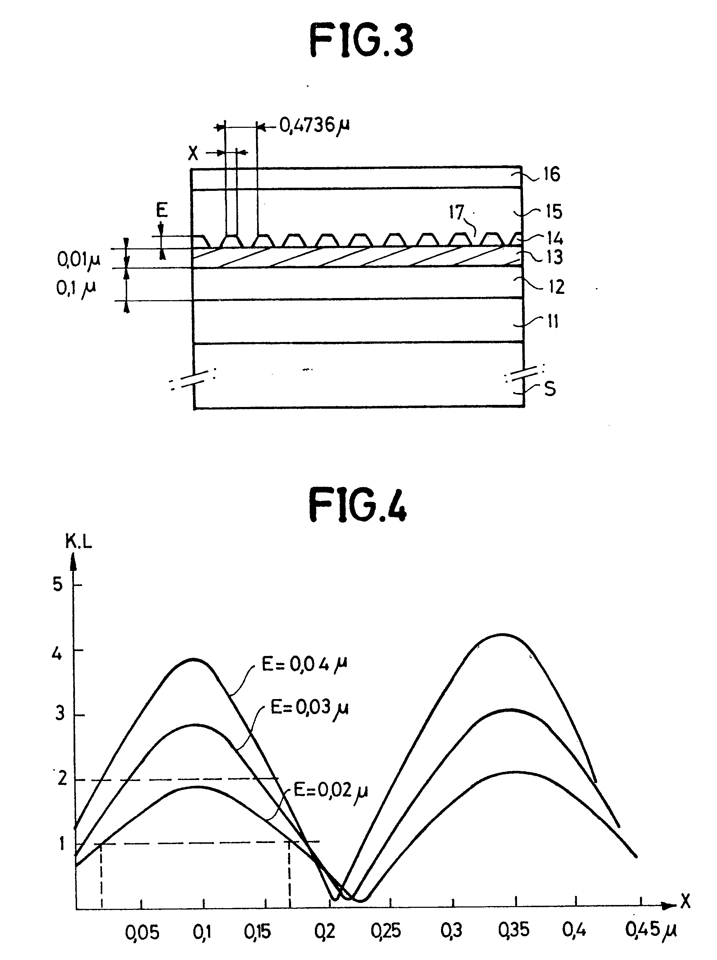

La figure 3 montre une coupe de la structure d'un laser DFB comportant un réseau réalisé par le procédé selon l'invention. Sa réalisation consiste successivement à :
- déposer, par épitaxie, sur un substrat S, une couche de confinement optique, 11, constituée de InP ;
- déposer, par épitaxie, une couche active 12 constituée de GaInAsP ayant une largeur de bande interdite égale à 1,5 micron et une épaisseur de 0,1 micron ;
- déposer, par épitaxie, une couche 13, dite couche d'arrêt, constituée de InP et ayant une largeur de bande interdite correspondant à une longueur d'onde de 0,92 micron et une épaisseur de 0,01 micron ;
- déposer, par épitaxie, une couche guidante 14 constituée de GaInAsP ayant une largeur de bande interdite correspond à une longueur d'onde de 1,5 micron et une épaisseur E ;
- déposer une couche de résine photosensible, et la découper selon la forme à donner au réseau de diffraction, par holographie UV ou par masquage électronique, selon un procédé classique de réalisation d'un masque au moyen d'une résine photosensible ;
- attaquer la couche guidante 14 au moyen d'un agent chimique sélectif qui n'attaque pas le matériau InP de la couche d'arrêt 13, ni la résine ; en le laissant agir jusqu'à ce que toute l'épaisseur de la couche guidante 14 ait été enlevée aux endroits non protégés par la résine, l'épaisseur E de la couche 14 étant choisie égale à l'épaisseur souhaitée pour le réseau de diffraction ;
- enlever la couche de résine par un solvant chimique classique ;
- déposer, par épitaxie, une couche de confinement optique 15 ;
- déposer, par épitaxie, une couche contact 16.

Ce procédé permet d'obtenir une profondeur de gravure précise et uniforme car elle est déterminée par l'épaisseur E de la couche 14. Cette épaisseur est déposée de manière uniforme et précise grâce aux techniques modernes d'épitaxie telles que les techniques MBE (Molecular Beam Epitaxy) ou MOCVD (Metal Organic Chemical Vapor Deposition). Ces techniques permettent la croissance de couches minces, ayant une épaisseur de quelques millièmes de micron jusqu'à quelques microns, constituées de matériaux de natures différentes et de compositions différentes, avec une grande homogénéïté et une excellente reproductivité. Les techniques d'attaque chimique sélective connues permettent, quant à elle, de graver un motif sur une couche de matériau semi-conducteur, avec l'assurance de ne pas altérer les couches voisines ayant des compositions différentes.

La profondeur de gravure étant fixée par l'épaisseur E de la couche 14, il est beaucoup plus facile de maîtriser ensuite la largeur des sillons 17 pour obtenir une largeur X des parties en relief, précise et uniforme. La seule contrainte imposée par ce procédé consiste à utiliser pour la couche 14 un matériau différent de celui de la couche 13 destinée à arrêter l'attaque chimique. Le matériau de la couche 14 peut éventuellement être le même que celui de la couche active 12, ce qui simplifie les opérations d'épitaxie. Dans certains dispositifs optiques, la couche 14, après gravure du réseau, peut constituer une structure guidante de type ruban, comme cela sera mentionné plus loin.

La figure 4 représente un diagramme donnant la valeur du facteur de couplage K.L en fonction de la largeur X des parties en relief laissées par la gravure et en fonction de l'épaisseur E de la couche 14 qui est gravée. Ces diagrammes sont tracés pour une structure laser telle que celle décrite ci-dessus et émettant à une longueur d'onde de 1,55 micron, avec un réseau du deuxième ordre. Sur ce diagramme il apparaît que pour une épaisseur E de la couche guidante 14 égale à 0,02 micron, le facteur de couplage obtenu reste compris entre 1 et 2, ce qui est recherché pour un bon rendement de fabrication, lorsque la largeur X varie de 0,03 micron à 0,18 micron. Ce bon rendement est obtenu lorsque E est supérieure E à 0,01 micron, et inférieure à 0,03 micron. La largeur X est facilement maîtrisable en agissant sur la durée de la gravure. Par conséquent, la valeur du facteur de couplage K.L est facilement maîtrisable. Cette facilité de mise en oeuvre constitue un avantage majeur pour la réalisation industrielle de composants opto-électroniques, notamment les lasers DFB et DBR.

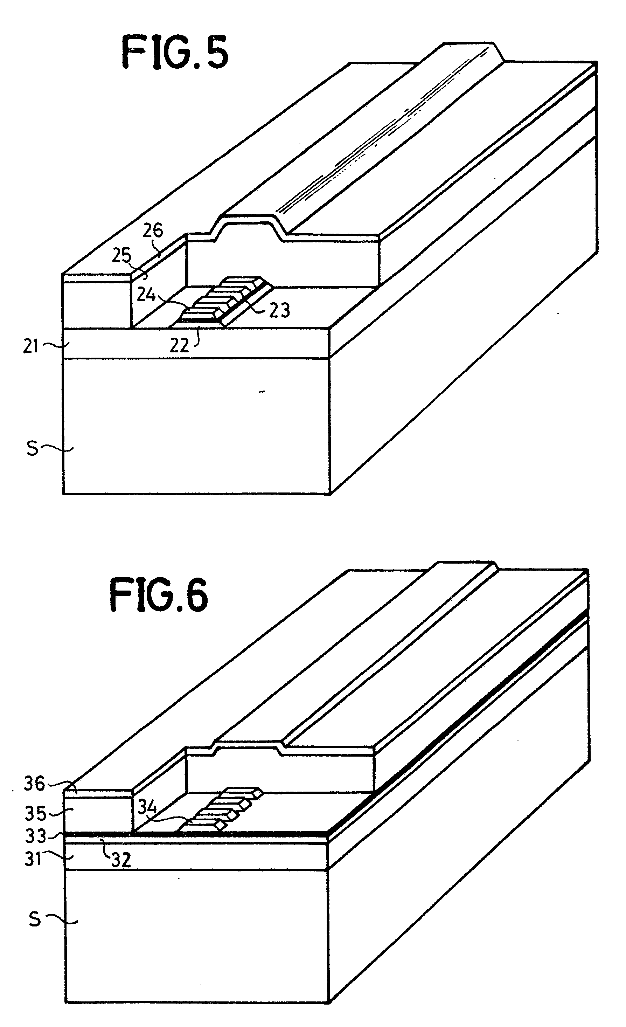

La figure 5 représente la structure d'un laser DFB à ruban enterré, comportant un réseau fabriqué par le procédé selon l'invention. Une couche de confinement 21, puis une couche active 22, puis une couche d'arrêt 23, puis une couche guidante 24 sont déposées successivement par épitaxie sur un substrat S. Ensuite un réseau est gravé dans la couche guidante 24 au moyen d'un premier masque de résine et d'une attaque chimique sélective par le procédé selon l'invention. Puis un second masque de résine et une attaque chimique non sélective sont utilisés pour découper à la fois les couches 22, 23 et 24, en laissant subsister un ruban dont le grand axe est perpendiculaire aux traits du réseau gravé dans la couche 24. Une reprise d'épitaxie permet de déposer une couche de confinement 25 puis une couche de contact 26 recouvrant à la fois ce ruban et la partie libre de la surface de la couche 22. Une localisation de l'injection dans le ruban peut être réalisée par différentes techniques : implantation protonique, diffusion, couches bloquantes, etc...

La figure 6 représente la structure d'un laser DFB à guide ruban enterré réalisé par le procédé selon l'invention. Une couche de confinement 31, une couche active 32, une couche d'arrêt 33, et une couche guidante 34 sont déposées successivement par épitaxie sur un substrat S. Dans la couche 34 un réseau est gravé au moyen d'un premier masque de résine et d'une première attaque chimique sélective, selon le procédé décrit précédemment. Puis, au moyen d'un second masque de résine et d'une seconde attaque chimique sélective, la couche 34 est gravée en forme de ruban dont le grand axe est orienté perpendiculairement aux traits du réseau. La couche active 32 et la couche d'arrêt 33 gardent une largeur égale à celle du substrat S, le matériau de la couche 33 constituant une couche d'arrêt aussi pour la seconde attaque chimique sélective. Les couches 31 à 34 constituent un guide ruban enterré. Une reprise d'épitaxie est réalisée ensuite pour déposer une couche de confinement 35 puis une couche de contact 36. Comme dans le cas précédent, une localisation de l'injection peut être effectuée par différentes techniques connues. Cette structure est très avantageuse par sa simplicité de réalisation.

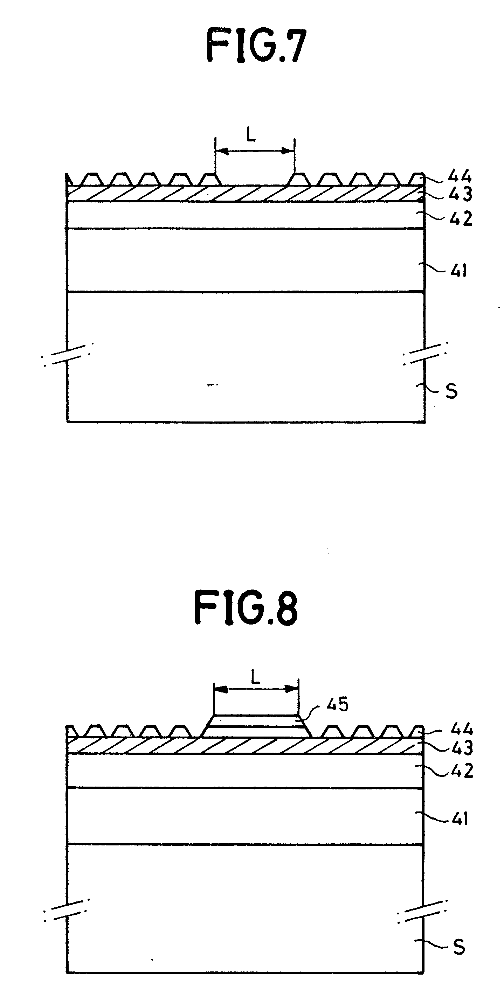

Les figures 7 et 8 représentent un autre type de dispositif opto-électronique, comportant un réseau et un déphaseur. Ces deux dispositifs comportent une couche de confinement 41, une couche active 42, une couche d'arrêt 43, et une couche guidante 44 déposées par épitaxie sur un substrat S. Un réseau est gravé dans la couche guidante 44 par le procédé suivant l'invention, mais la surface du réseau comprend deux parties distinctes séparées par une zone de largeur L et dont la longueur est parallèle aux traits du réseau. La largeur L détermine le déphasage réalisé par le passage d'une onde à travers cette zone.

Dans l'exemple de réalisation de la figure 7, la zone de largeur L est une zone où la couche 44 a été entièrement enlevée par une seconde attaque chimique sélective, un second masque étant utilisé pour protéger la partie où le réseau doit subsister. Il est possible aussi de réaliser la gravure de cette zone avant la gravure du réseau. La largeur L détermine le déphasage réalisé par le passage d'une onde à travers cette zone.

Dans l'exemple représenté sur la figure 8, le déphasage est réalisé au contraire par une zone de largeur L où la couche guidante 44 n'est pas attaquée lors de la gravure du réseau, grâce à une couche de protection 45 qui est constituée d'un matériau semi-conducteur différent de celui de la couche 44. Un premier masque de résine et une première attaque chimique sélective sont utilisés pour enlever la couche 45 sauf sur une zone constituant le ruban de largeur L, et sans attaquer la couche 44. Puis un second masque et une seconde attaque chimique sont utilisés pour graver le réseau dans la couche 44, sans attaquer la couche 45, ni la couche 43. La couche 44 reste donc intacte sous le ruban de largeur L, et elle peut être utilisée pour un guidage latéral. Dans cet exemple, la couche 45 est constituée de InP et ne joue pas de rôle dans le déphasage. Dans d'autres exemples de réalisation, la couche 45 peut être constituée d'un matériau quaternaire et peut jouer un rôle dans le déphasage.

La portée de l'invention ne se limite pas aux exemples de réalisations décrits ci-dessus. Notamment le procédé de réalisation d'un réseau de diffraction est applicable à des dispositifs électro-optiques autres que des dispositifs à structures guidantes. D'autre part, il est applicable à des dispositifs comportant plusieurs réseaux de diffraction gravés dans des couches superposées. Par exemple, il est envisageable de graver un premier réseau de diffraction dans une couche guidante constituée d'un matériau quaternaire déposée sur une couche d'arrêt constituée d'un matériau binaire ; puis de déposer, par dessus le premier réseau, une autre couche d'arrêt constituée d'un matériau binaire ; puis de déposer une autre couche de matériau quaternaire et de graver un second réseau dans cette autre couche de matériau quaternaire. Il est possible aussi de réaliser un tel dispositif en partant d'un ensemble de couches alternativement constituées de matériau binaire et de matériau quaternaire, et en faisant des attaques chimiques sélectives successives.

Les applications du procédé selon l'invention ne se limitent pas aux lasers et aux coupleurs intégrés. Elles peuvent être appliquées à toutes les fonctions de l'optique intégrée comportant un ou plusieurs réseaux de diffraction.

Le procédé selon l'invention peut être appliqué à de nombreuses familles de matériaux semi-conducteurs, en particulier les composés III-V et leurs solutions solides telles que GaInAsP, GaInAs, GaAlAs, GaInAlAs, GaInAlSb, etc...

La couche guidante, sur laquelle est gravée le réseau, peut être constituée de plusieurs sous couches de matériaux différents, de façon à constituer une structure à multi-puits quantiques.

**Revendications**

1. Procédé de réalisation d'un réseau de diffraction sur un matériau semi-conducteur, caractérisé en ce qu'il consiste successivement à :
- déposer, par épitaxie, une première couche (13) dite couche d'arrêt, constituée d'un premier matériau semi-conducteur, ayant une épaisseur comprise entre 0,005 et 0,02 micron ;
- déposer, par épitaxie, une seconde couche (14) constituée d'un second matériau semi-conducteur ayant une composition différente de celle du premier, et ayant une épaisseur égale à la profondeur des traits (17) du réseau à réaliser, et comprise entre 0,01 et 0,03 micron ;
- déposer un masque ayant la forme à donner au réseau de diffraction qui est à réaliser ;
- attaquer la seconde couche (14) à travers le masque, au moyen d'un agent chimique sélectif qui n'attaque pas le matériau de la première couche (13), et le laisser agir jusqu'à ce que toute l'épaisseur de la seconde couche (14) ait été traversée ;
- enlever le masque.

2. Procédé selon la revendication 1, caractérisé en ce que le matériau semi-conducteur constituant la seconde couche (14) est un composé quaternaire, et en ce que le matériau semi-conducteur constituant la première couche (13) est un composé binaire.

3. Dispositif opto-électronique, comportant un réseau de diffraction réalisé par le procédé selon l'une des revendications 1 ou 2, caractérisé en ce qu'il comporte au moins :
- une première couche (13) constituée d'un premier matériau semi-conducteur, ayant une épaisseur comprise entre 0,005 et 0,02 micron ;
- une seconde couche (14) constituée d'un second matériau semi-conducteur ayant une composition différente de celle du premier ; ayant une épaisseur comprise entre 0,01 et 0,03 micron ; et creusée à travers toute son épaisseur par des sillons (17) parallèles entre eux constituant un réseau de diffraction.

4. Dispositif opto-électronique selon la revendication 3, ayant une structure guidante, caractérisé en ce qu'il comporte :
- une couche (11), dite couche de confinement optique, constituée d'un premier matériau semi-conducteur ;
- une couche (12), dite couche active, constituée d'un second matériau semi-conducteur ;
- une couche (13), dite couche d'arrêt, constituée d'un troisième matériau semi-conducteur ayant une composition différente de celle du second matériau semi-conducteur ;
- une couche guidante (14), constituée d'un quatrième matériau semi-conducteur ayant une composition différente de celle du troisième matériau semi-conducteur, et creusée à travers toute son épaisseur par des sillons parallèles entre eux et constituant un réseau de diffraction.

# FIG.1

# FIG.2

# FIG.3

# FIG.4

# FIG.5

# FIG.6

# FIG.7

# FIG.8

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | PATENT ABSTRACTS OF JAPAN, vol. 10, no. 329 (E-452)[2385], 8 novembre 1986, page 19 E 452; & JP-A-61 134 096 (MATSUSHITA ELECTRIC IND. CO., LTD) * Résumé * | 1-4 | H 01 L 21/308 H 01 L 33/00 H 01 S 3/06 |
| A | PATENT ABSTRACTS OF JAPAN, vol. 2, no. 22 (E-13), 14 février 1978, page 11453 E 77; & JP-A-52 141 189 (NIPPON DENSHIN DENWA KOSHA) 25-11-1977 * Résumé * | 1,3,4 | |
| A | EP-A-0 217 627 (SHARP K.K.) * Page 3, ligne 14 - page 5, ligne 33; figures 1,5 * | 1,3,4 | |
| A | PATENT ABSTRACTS OF JAPAN, vol. 9, no. 291 (E-359)[2014], 19 novembre 1985, page 138 E 359; & JP-A-60 132 380 (HITACHI SEISAKUSHO K.K.) 15-07-1985 * Résumé * | 1,3 | |
| A | PATENT ABSTRACTS OF JAPAN, vol. 9, no. 47 (E-299)[1770], 27 février 1985, page 129 E 299; & JP-A-59 188 187 (NIPPON DENKI K.K.) 25-10-1984 * Résumé * | 1-3 | DOMAINES TECHNIQUES RECHERCHES (Int. Cl.4) H 01 L H 01 S G 02 B |
| A | PATENT ABSTRACTS OF JAPAN, vol. 12, no. 153 (E-607)[3000], 11 mai 1988; & JP-A-62 266 889 (FUJITSU LTD) 19-11-1987 * Résumé * | 1-4 | |

Le présent rapport a été établi pour toutes les revendications

| Lieu de la recherche | Date d'achèvement de la recherche | Examinateur |
|---|---|---|
| LA HAYE | 16-03-1989 | GNUGESSER H.M. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
 
& : membre de la même famille, document correspondant

EPO FORM 1503 03.82 (P0402)